# EUROPEAN PATENT SPECIFICATION

(11) **EP 3 287 847 B1**
(45) Date of publication and mention of the grant of the patent: **10.06.2020**
(21) Application number: 16782572.8
(22) Date of filing: 13.04.2016
(51) Int. Cl.: G03F 7/09, B41C 1/10, G03F 7/004, G03F 7/095

(54) **POSITIVE-IMAGE THERMOSENSITIVE LITHOGRAPHIC PRINTING PLATE**
WÄRMEEMPFINDLICHE LITHOGRAFISCHE POSITIVBILD-DRUCKPLATTE
PLAQUE D'IMPRESSION LITHOGRAPHIQUE THERMOSENSIBLE À IMAGE POSITIVE

(30) Priority: 21.04.2015 CN 201510190791
(43) Date of publication of application: 28.02.2018
(73) Proprietor: Qingdao Lanfan Advanced Materials Co. Ltd., Qingdao, Shandong 266000 (CN)
(72) Inventor: LIU, Yang, Qingdao, Shandong 266000 (CN)
(74) Representative: Casalonga
(86) International application number: PCT/CN2016/079172
(87) International publication number: WO 2016/169425

(56) References cited:
- EP-A1- 2 365 389
- CN-A- 1 603 956
- CN-A- 104 503 204
- CN-A- 104 503 204
- CN-A- 104 827 795
- US-A1- 2011 217 656

## Description

### BACKGROUND OF THE PRESENT INVENTION

### FIELD OF INVENTION

The present invention relates to a thermosensitive lithographic printing plate material, and more particularly to a thermosensitive lithographic printing plate material applying to computer-to-plate.

### DESCRIPTION OF RELATED ARTS

Computer image processing technology was brand-new in the late 1990s. The computer image processing technology was mastered only by a handful of leading companies. After 2010, the computer-to-plate system increasing popularity in China. As the deepening of research and development of material manufacturers for coating material, the plate manufacturers continuously improve and break plate material coating-related processes and technologies. Plate material applying to computer-to-plate has been developing rapidly in China.

Whether for positive lithographic printing plates or for negative lithographic printing plates, the basic imaging principle is certain changes of print plate coating materials are caused by a method. The changes result in solubility difference of coating materials in matching developing liquid, so that the imaging process is realized. The method cannot do without electromagnetic waves. The only difference between positive and negative is that after being exposed to electromagnetic waves, the change of solubility thereof is entirely different. Positive lithographic printing plate materials change from un-dissolving (or slightly dissolving) to being dissolved in, namely a so-called positive-affect is formed; negative lithographic printing plate materials change from being dissolved in to un-dissolving, namely a so-called negative-affect is formed. Ultimately, these changes are determined by the reactivity of the components of the coating composition to electromagnetic waves. Printing plates needed by negative plate imaging can be obtained if the electromagnetic wave causing polymerization principle is used to the designing coating compositions. Printing plates needed by positive plate imaging can be obtained if the electromagnetic wave causing decomposition principle is used to the designing coating compositions. Here so-called decomposition refers to breaking by a broad sense, including the destruction of chemical bonds between atoms of the composition of the constituent and the breaking of hydrogen bonds between component molecules.

So far, referring to the known positive plates, regardless of light sources, the imaging mechanism can be explained well by explaining the changing of hydrogen bonds between molecules. As force which is different from the chemical bond and van der Waals force, hydrogen bond is an important secondary bond. Hydrogen bond energy is the energy being required to decompose X-H...Y-H into HX and HY. Although hydrogen bond is a kind of weak bond, but because of its presence, nature of the material, such as melting points, boiling points, solubility, viscosity, density, acidity of materials become different. A hydrogen atom which forms a strong polar bond with an atom having great electrically negativity exists; an atom B (F, 0, N) having a smaller radius, a larger electronegativity, containing lone pair of electrons, with partial negative charge exists. Hydrogen bonds are formed between different molecules matching the above two conditions. Therefore, referring to positive plate coating composition, the insolubility of non-exposed regions lies on the forming of hydrogen bonds between its components. The dissolving of the exposed regions lies on the destruction to the hydrogen bonds by the radiation energy. Referring to the meaning of hydrogen bonds, the nature of the positive plate imaging process can be seen as a physical process. Hydrogen bond force is the key to determine the performance of the positive image lithographic printing plate. Thus, to divide the role of components of the coating composition of positive plate coatings, concept of alkali-soluble resin and concept of solvent resistance agent are applied based on the nature of materials. In a manner of speaking, alkali-soluble resin and solvent resistance agents are the key basic material to form positive plates coating compositions. Furthermore, according to the requirements to light source which should be met, the help of the light-sensitive material is needed. According to the conventional positive PS plate, the photosensitive substance being used is 1-diazo-2-naphthoic sulfonate esters. This substance is not only used as a solvent-resistance agent, but also is used to transfer energy, which can form hydrogen bond with the alkali-soluble resin molecular in the coating composition. Under the shield of hydrogen bond, the composition show good non alkali-soluble. After being exposed to UV visible light, 1-diazo-2-naphthoic sulfonate ester compounds decompose, so that the original hydrogen bonds are destroyed, phenolic hydroxyl group of the composition alkali-soluble phenolic resin lost shield, so as to dissolve in the developing liquid. Furthermore, decomposition chemicals of 1-diazo-2-naphthoic sulfonate esters also form carboxylic acid after meet water, so that the dissolution of the composition in visible light region is further promoted. It can be said that for the traditional positive PS plate, the imaging process is a physical process with the help of chemical change. The core of this imaging technology is the use of the photosensitive characteristics of materials. According to this principle, the dissolution difference between see the light region and the non-light region is large, so that the printing plate can get good resolving power characteristics easily.

The photosensitive materials used by the positive image thermosensitive lithographic printing plate material technology are near-infrared-absorbing dyes matching the emission wavelength of near-infrared laser. By beam irradiation of an infrared laser, absorbing dyes in the coating material which is coated to the aluminum substrate convert light energy into heat energy. Under the influence of heat, transient phase change or decomposing occurs to coating component, so that the hydrogen bonds originally present between the components are damaged, so that alkali-soluble differences between irradiation regions and non-illuminated regions are demonstrated, so that images are formed.

The process that coating material molecules change in solubility via being exposed to infrared laser beams is the basic principle of thermal lithographic printing plate imaging.

Thus, the differences of the alkali-soluble of coating material between the exposed regions and the non-exposed regions determine the sensitivity and finesse to achieve imaging plate, namely resolving power of plates, thereof. In conventional technology research, it is given much research in how to balance to large alkali-soluble difference between exposure state and non-exposure state of coating component. For example, the patent published in eighties and nineties last century, JP-A-60-175046, JP-A6-43633, JP-A7-20629, JP-A-7-271029, EP0823327 described in this regard. EP0823327 describes a positive type infrared thermal composition, which said to provide a very simple system forming positive image. The system comprises a light-thermal conversion material and an alkali-soluble resin. The process to form a positive image does not require a chemical change. It also pointed out that the reason why the photosensitive component can provide such excellent effect is not clear. The reason can be considered as light-thermal conversion agents convert light energy to heat energy firstly. The function of heat makes the alkali-soluble resins occur some non-chemical changes, such as changes in the conformation, so that the solubility in alkaline water of the resin in the heated portions increase, so that the images are formed. It also proposed that the alkali-soluble of materials are increased via radiation action, such as O-diazo naphthoquinone compounds, or a combination of a kind of light-acid generating agent. In essence, it is not necessary to increase the alkali-soluble through producing acid. This patent proposes to consider introducing a kind of substance having thermal decomposition characteristic during compatibility thermosensitive composition. It is the key to manufacture excellent plate materials to improve the alkali-soluble composition differences between radiation regions and non-radiation regions via chemical changes which occurs after being heated.

According to the application of the positive image thermal sensitive plates the basic indicators to evaluation quality of the materials include the applicability of the printing medium, resolving power and anti-printing forces. According to the conventional technology, people add various functional acrylic copolymers in the recipe to improve applicability and print-resistance of the thermal plate to print mediums. For example, CN1891455A introduces to improve the solvent resistance of lithographic printing plates via adding acrylamide and acrylic sulfonamide to formulations of sensitive layer of the lithographic printing plate. CN1688657A (EP1554346B1), introduced to add N-imide groups to formulation of the lithographic printing plate sensitive layer to improve the solvent resistance of the lithographic printing plate. European patents EP1506858 and EP1738900 introduced to add N-vinyl amide polymer to formulation of lithographic printing plate thermal sensitive layer to improve solvent-resistance ability of the lithographic printing plate. WO2004035645 introduced a process to join amide and imide structural units to the phenolic resin to improve solvent-resistance ability of the lithographic printing plate. However, although the solvent-resistance ability of the lithographic printing plate is improved, new problems occur. While the solvent-resistance ability of the lithographic printing plate improving, alkali resistance increasing ability of the plates become weaker, the scratch resistance ability of the coating layer become weaker.

Patents EP0864420B2 and US6040113 proposed to resolve the issue by applying a dual or multi-layer coating solution.

I.e. an alkali-soluble hydrophobic polymer layer is coated to the hydrophilic base surface and then an infrared-sensitive top layer is coated thereon. The under coating resin is a phenolic resin, a polyvinyl alcohol resin or a carboxylic acid-containing polymer resin. Patents US6192799 and EP0950518B1 proposed multi-coating positive thermal printing plate includes a hydrophilic substrate, a first layer of alkali developing liquid and an infrared sensitive top which can not be dissolved to alkaline developing liquid. At least one of the two layers contains surfactants. The base resin layer applies nitro-celluloses. Patent WO2009023103 presented supporting bodies containing a hydrophilic surface of positive imaging material include an inner layer, main polymer binders containing N-alkyl methyl (alkyl) acrylamide or one or more repeating units derived by alkoxymethyl (alkyl) acrylic acid and acetal repeating units in turns. The technology advantages to manufacture positive thermal sensitive plate apply the method of double or multi-layered coating is that it can deal with materials with different physical and chemical properties separately. Thus, the problem of the material advantages is weaken in the single-coating condition can be avoided. Give full play to performance advantages of each coating composition. High-performance positive thermal CTP printing plates are usually manufactured using this technology. Lower layer of double coating positive thermal CTP plate applies different copolymer resins to improve the chemical resistance of the plate materials, but the binding force between the plate resin layer and hydrophilic base has a problem. In the non-imaging region, the photosensitive layer can not be completely removed during developing, which remains on the surface of carriers, so the ink is adhesive to the remaining layers to contaminate non-image regions, so it is easy to stay ink to the bottom, to reduce the sensitivity, to reduce the developing latitude. It leads to outlets "pull erosion" phenomenon to resolve the problem of ink remaining at the bottom only rely on adjusting the proportion of alkali-soluble group of the copolymer resin structural units, or to help dissolving and clearing the copolymer resin in the non-imaging region via adding development accelerators. The whole screen dot has an inverted trapezoidal shape. Especially, fine mesh wire having size of 1*1 and 3% screen dot usually show a "virtual stay" phenomenon. Screen dots are the basis of copying printing materials and color reproductive, which bears the task of transferring the original color and levels. Screen dots are the smallest unit which adsorb ink in offset printing and true reflection to realize the copying of print tone, levels and color reproduction. Therefore, "pull erosion" phenomenon, which is caused by said lower layer solubility inhibition of said lower layer, will make the difference between the upper and lower outlets increases, which result in abrupt change of outlets, so that to cause the change of print resolution and subtle level of printing materials an d problems about contrast, ink color, ink density and ink trapping, etc., so as to result in the volume apparent differences of printing. Patents JP2000108538 and CN101027611 proposed to add a subbing layer between the carrier and an image-forming layer thereon, so as to avoid polluting the non-imaging regions. The subbing layer includes polymers. The polymers include monomers having acid groups and monomers having groups of Om. However, a problem is caused. The subbing layer is added between the plate material layer and the resin layer, so a coating layer is added, and the subbing layer is thin, so as to add the difficult in production. Thus, changes of dissolving and retaining of underlying composition in the alkaline developing liquid can not rely solely on the protection of upper thermal layer.

CN 104503204 A and EP 2365389 disclose a positive image thermosensitive lithographic plate material comprising a hydrophilic bottom layer coated with a top layer.

### SUMMARY OF THE PRESENT INVENTION

The invention is advantageous in that it provides a double-coated positive image thermosensitive lithographic plate material. The plate material has high sensitivity, excellent development latitude, chemical resistance and resolving power.

Additional advantages and features of the invention will become apparent from the description which follows, and may be realized by means of the instrumentalities and combinations particular point out in the appended claims.

According to the present invention, the foregoing and other objects and advantages are attained by a positive image thermosensitive lithographic plate material as claimed comprising a hydrophilic layer. The hydrophilic layer is coated with a lower layer and a top layer in turn. The hydrophilic layer is sensitive to infrared radiation. While being exposed to infrared laser, the dissolving ability of the coating components of the exposure regions in alkaline developing liquid is increased, so that the coating components are cleared by alkaline developing liquid. Non-exposed regions are not dissolved, so as to be remained on the plate, so as to form images.

The lower layer of the hydrophilic layer is as defined in claim 1.

The alkali-soluble copolymer resin is an acrylic copolymer of formula (I), which contains at least one structural unit of alpha-Toluenesulfonamide Acrylamide monomer. The molecular weight of the copolymer is 1,000 to 100,000. The mass fraction of alpha-Toluenesulfonamide Acrylamide monomer in the copolymer is 5% to 70%. The mass percentage content of alkali-soluble resin in said lower layer thermal composition is 60 to 80%. 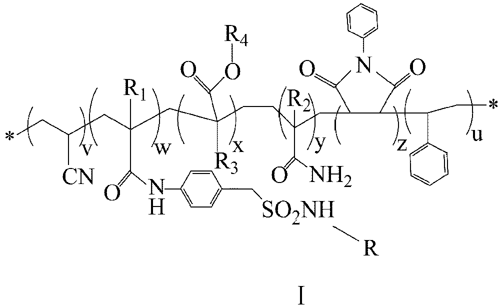 wherein R is selected from the group consisting of -H, -(C₁ ∼ C₄) alkyl and aryl; wherein R₁, R₂ and R₃ is independently selected from the group consisting of-H and - CH₃; wherein R₄ is selected from the group consisting of-CH₃ and -C₂H₅; wherein v, w, x, y, z and u respectively represents mass fraction of each monomer in the copolymer molecule. The mass fraction of each sad monomer is 0% to 70%; wherein the sum of the monomers represented by v, w, x, y, z and u is 100%.

Dissolution inhibitor is able to be used to decrease the solubility of the unexposed portions. It is able to improve the solubility difference between radiation regions and non-radiation regions in alkaline developing liquid, so as to balance the dissolution rate in alkaline developing liquid between the upper radiation regions and the lower radiation regions, so as to form better images.

Furthermore, the dissolution inhibitor of the lower layer is ester of diazonaphthoquinone sulfonyl chloride and acrylic copolymer containing N-(4-hydroxyphenyl) maleimide cyclic units which is represented by formula (II). The molecular weight of the copolymer carrier is 1,000∼50,000; the mass percentage of ester in the lower layer thermosensitive composition is 10∼30%. 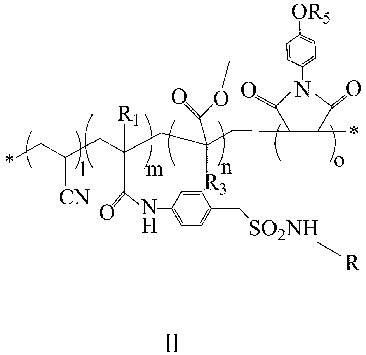 wherein R is selected from the group consisting of -H, -(C₁∼C₄) alkyl and aryl; wherein R₁ and R₃ is independently selected from the group consisting of -H and CH₃; wherein R₅ is diazonaphthoquinone sulfonate of formula (III). The sum of the mass fractions of components respectively being representative by 1, m, n and o, is 100%. The mass fraction of component being representative by o is 40% ∼50%; the esterification rate thereof is 50% ∼90%.

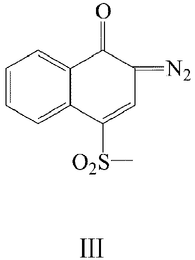

Furthermore, the dissolution inhibitor used in the top layer is 1,2-naphthoquinone-2-diazo-4-sulfonic acid ester compound; the esterified precursor thereof is low molecular weight polyhydric phenol compounds and pyrogallol-acetone polycondensates. The weight average molecular weight of the esterified precursor is 50∼5000; Mw/Mn thereof is 1.5∼20, hydroxy esterification rate is 10%∼80% of the initial hydroxyl groups; the mass percentage of dissolution inhibitor in the top layer thermosensitive composition is 2%∼5%.

Furthermore, the phenolic resins in the top layer are novolac resins which are condensed by formaldehyde and phenols, such as phenol, m-cresol, o-cresol, p-cresol, phenol and m-cresol(mole ratio thereof is 3:7∼7:3), phenol and tert-butyl phenol(mole ratio thereof is 3:1∼1.5:1), m-cresol and p-cresol (mole ratio thereof is 9:1∼5:5), m-,o-cresol, 2,4-xylenol, 3,5-xylenol, m-/p- mixed cresol modified by N-phenyl maleimide; the weight average molecular weight thereof is 8000∼30000; the amount thereof being added is 86.5% ∼ 89.5% of the whole top layer heat-sensitive composition in weight.

Due to the exist of hydrogen bond among dissolving inhibitors, phenolic resins and acrylamide copolymers, the coating material is not dissolved in alkaline developing liquid. After the plate material being exposed, diazonaphthoquinone groups of the dissolving inhibitor decompose at high temperature, so that the action of hydrogen bonds disappear, so that phenolic hydroxyl groups and sulfonamide groups lost a shadowing effect, so as to be dissolved while meeting alkaline. Meanwhile, carboxylic acid groups being formed by diazonaphthoquinone groups through thermal decomposition, meeting water can also accelerate the dissolution of the exposed portions. Its decomposition mechanism is depicted in scheme below:

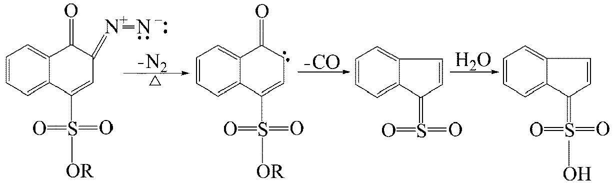

Furthermore, heat-sensitivity of the lower layer and the top layer is realized by adding near-infrared dyes. The near-infrared-absorbing dyes can be infrared available absorbing dyes according to the prior art, for example, cyanine dyes, hemicyanine dyes, polymethine dyes, diimine dyes, squaraine dyes, croconium dyes, methine, aromatic methine, polymethine, pyrylium salt dyes, thiopyran dyes, naphthoquinone dyes, anthraquinone dyes, oxazole salt dyes, thiazole salt dyes, merocyanine, chain cyanine, hidden cyanine, naphthalocyanine, phthalocyanine, sulfur phthalocyanine, porphyrin, indole cyanine tricarbonyl, indole salt dyes, polypyrrole, pyrazoline azo, glucosinolates pyran aryl, oxazine, polythiophene. Among these, cyanine dyes and diimonium salt dyes are preferred. The maximum absorption peak of the dyes is 700nm-1300nm. These near-infrared absorbing dyes can absorb infrared radiation, so as to convert light energy into heat energy while being exposed to the infrared-ray.

Furthermore, the near infrared absorbing cyanine dyes can be one kind of dye or a mixture of two kinds of dye which have different maximum absorption peak values, wherein the ratio of the two kinds dyes is 1: 2∼2: 1. The total amount of the near-infrared absorbing dyes is 0.5% to 2% in the lower layer thermal composition and is 1% to 4% in the top thermosensitive composition.

Furthermore, the weight of the lower coating is 0.8-1.2g/m², the weight of the top layer coating is 0.6-1.0g/m².

The development accelerator of the hydrophilic layer is a mixture of carboxylic acid, carboxylic anhydride, sulfonic acid and phosphoric acid compounds. The amount of the development accelerator being added in is 1%∼4% of the amount of the lower layer thermosensitive composition in weight, and is 1%∼2.5% of the amount of the top layer thermosensitive composition in weight.

The background coloring dye of the hydrophilic layer is one dye selected from the group consisting of Victoria pure blue, alkaline Brilliant Blue, oil-soluble blue, crystal violet, ethyl violet, methyl violet and methylene blue, or a mixture of the dyes selected from the group consisting of Victoria pure blue, alkaline Brilliant Blue, oil-soluble blue, crystal violet, ethyl violet, methyl violet and methylene blue.

The amount of the coloring dye is 1%∼4% of the amount of the lower layer thermosensitive composition in weight, and is 0.5%∼2% of the amount of the top layer thermosensitive composition in weight.

The surfactants are polyethoxy dimethylpolysiloxane copolymers.

The two layers of composition according to the present invention can be dissolved into one, two, three or more solvents, so as to prepare a coating solution, wherein the percentage of the solution is 6 %∼13% by mass. The solvent being used in the present invention is selected from the group consisting of acetone, methyl ethyl ketone, cyclohexane, ethyl acetate, dichloroethylene, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetyl acetone, cyclohexanone, diacetone alcohol, ethylene glycol monomethyl ether acetate, glycol ethyl ether acetate, ethylene glycol mono-isopropyl ether, ethylene glycol monobutyl ether acetate, 3-methoxy propanol, methoxy methoxy ethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, methoxypropyl acetate, N, N-dimethylformamide, dimethyl sulfoxide, γ-butyrolactone, methyl lactate ester and ethyl lactate. These solvents may be used alone or as a mixture.

The supporting body being used in the present invention for coating is the standard aluminum alloy plate. The thickness thereof is 0.27∼0.3mm. The recipe uses aluminum in best. The surface of the plate is treated via known surface treatment methods to obtain a hydrophilic surface.

The coating solution can be coated to the aluminum plate having the hydrophilic surface via a method selected from the group consisting of rotary coating, immersion coating, anilox roller coating, air pruning coating, roll coating, blade coating and curtain coating etc. The order of coating is the lower layer is coated first. After the lower layer is dried, the top layer is coated and then dried to obtain the printed plate.

The imagewise exposing of the double layer positive image thermosensitive lithographic printing plate material can be realized via exposing into infrared, near-infrared laser or the laser beam. The wavelength range thereof is 800∼1200nm. This method can be realized easily via a laser scanning imaging laminator, such as: Kodak Trendstter 800ua Platesetter 800U Trendsetter (made by Kodak Co.) and PlateRite 8600M-S (made by Screen Co., Ltd.).

### The developing process:

The developing liquid of the positive image thermosensitive lithographic printing plate material may be any liquid or solution that can penetrate and dissolve the exposed regions of the photosensitive layer, while the unexposed regions can not be penetrated and dissolved. The developing liquid of traditional printing plate material is dilute alkali solution. Via giving the plate material a developing process, a relief image is remained on the plate surface. The relief image is slightly raising formed by the non exposed regions of the light photosensitive layer. Whether the non-image portions of the photosensitive layer can be completely removed from the layout after developing or not, the key is the solubility of the photosensitive layer to dilute alkali.

The common developing liquid used by thermosensitive plates is alkaline solution, which mainly consisting of developing agents, protection agents, wetting agents and solvents. The developing agents are used to dissolve the exposed photosensitive layer of the positive image CTP plate. Strong alkaline substance, such as sodium hydroxide, potassium hydroxide, sodium silicate and potassium silicate is used. The protective agents are also known as inhibitors, which can help to stabilized the performance of the developing liquid, and can reduce the erosion of the plate by the developing agents in the developing process, and can protect the graphic parts of the photosensitive layer from being etched by the developing liquid. The role of the wetting agent is to reduce the surface tension of the developing liquid, so that the developing liquid can wet the plate surface rapidly and uniformly, so as to facilitate the uniform of the developing. Commonly used wetting agents are sodium dodecyl benzene sulfonate, Twain and other surfactants. They are all viscous liquid. The above two surfactants not only have wettability, but also have emulsifying properties, so they have the function of helping the printing plate to be washed in the developing process. The solvent of the developing liquid is water, typically deionized water.

The manufacturing method of making the lithographic printing plate further comprises a process of adding protective colloid.

The beneficial effects of the present invention are: the positive image thermosensitive lithographic printing plate material plates containing the above alkali-soluble resin have a high sensitivity, good developing latitude, good chemical resistance and good resolving ability.

Still further objects and advantages will become apparent from a consideration of the ensuing description and drawings.

These and other objectives, features, and advantages of the present invention will become apparent from the following detailed description, the accompanying drawings, and the appended claims.

### DETAILED DESCRIPTION OF THE PREFERRED EMBODIMENT

The following description is disclosed to enable any person skilled in the art to make and use the present invention. Preferred embodiments are provided in the following description only as examples and modifications will be apparent to those skilled in the art. The general principles defined in the following description would be applied to other embodiments, alternatives, modifications, equivalents, and applications without departing from the scope of the appended claims.

The present invention will be described by the following embodiments, but the scope of the present invention is not limited to the following embodiments.

### Synthesis of acrylic resin AUVRl:

A stirrer, a condenser and a dropping funnel was set to a 1000ml four-necked flask. Nitrogen gas was inlet. 300ml ethyl cellosolve, 0.8g dibenzoyl peroxide, 7g APDMM, 8g acrylonitrile, 10g ethyl methacrylate and 12g acrylamide wass added. The stirrer was started to stir to dissolve. Heat up to 80°C. After 1 hour is used to react, a mixed monomer (0.8g dibenzoyl peroxide, 7g APDMM, 8g acrylonitrile, 10g ethyl methacrylate and 12g acrylamide is dissolved into 300ml ethyl cellosolve) is dropped. The dropping was finished in 1 hour. The reaction was continued for 4 hours. After the reaction is completed. Cooled reactant to room temperature. 0.5g hydroquinone which was dissolved in 50ml ethyl cellosolve is was added. The reactant was stirred for 10 minutes. Then the reactant was added into 4 liters of water, so as to obtain white solid. Via the process of being filtered, being washed for three times and being dried in a vacuum oven, the acrylic resin AUVR1 is obtained. The weight average molecular weight of the acrylic resin AUVR1 was tested by a gel permeation chromatography (Aglilient Technologies 1120Compact LC) (GPC). The testing conditions are: polystyrene was used as the standard; GPC column: 708 ^{∗} 300MM; detecting wavelength: 220nm; sample concentration: 1.0mg/ml; injection volume: 20µl; mobile phase: tetrahydrofuran; column temperature: 35°C. Via the gel permeation chromatography system, the weight average molecular weight Mw, the number average molecular weight Mn, the molecular weight distribution of the synthetic resin sample was measured. The weight average molecular weight Mw here concerned is 45000.

### Synthesis of acrylic resin AUVR2:

A stirrer, a condenser and a dropping funnel was set to a four-necked flask(1000ml). Nitrogen gas was inlet. ethyl cellosolve(400ml), dibenzoyl peroxide(0.6g), APDMM(3g), methacrylic acid(3g), styrene(5g), acrylonitrile(3g), N-phenylmaleimide(9g) and acrylamide(15g) was added. The stirrer was started to stir to dissolve. Heat up to 80°C. After 1 hour is used to react, a mixed monomer (dibenzoyl peroxide(0.6g), APDMM(3g), methacrylic acid(3g), styrene(5g), acrylonitrile(3g), N-phenylmaleimide(9g) and acrylamide(15g) is dissolved into ethyl cellosolve(400ml)) is dropped. The dropping was finished in 1 hour. The reaction was continued for 4 hours. After the reaction is completed. Cooled reactant to room temperature. hydroquinone(0.5g) which was dissolved in ethyl cellosolve(50ml) is was added. The reactant was stirred for 10 minutes. Then the reactant was added into 4 liters of water, so as to obtain white solid. Via the process of being filtered, being washed for three times and being dried in a vacuum oven, the acrylic resin AUVR2 is obtained. The weight average molecular weight of the acrylic resin AUVR2 was tested by a gel permeation chromatography (Aglilient Technologies 1120Compact LC) (GPC). The testing conditions are: polystyrene was used as the standard; GPC column: 708 ^{∗} 300MM; detecting wavelength: 220nm; sample concentration: 1.0mg/ml; injection volume: 20µl; mobile phase: tetrahydrofuran; column temperature: 35°C. Via the gel permeation chromatography system, the weight average molecular weight Mw, the number average molecular weight Mn, the molecular weight distribution of the synthetic resin sample was measured. The weight average molecular weight Mw here concerned is 51000.

### Synthesis of copolymer carrier BB:

A stirrer, a condenser and a dropping funnel was set to a four-necked flask(1000ml). Nitrogen gas was inlet. ethyl cellosolve(300ml), dibenzoyl peroxide(0.6g) and APDMM(5g) was added. The stirrer was started to stir to dissolve. styrene(8g), acrylonitrile(6g) and N-(4-hydroxyphenyl) maleamic (19g) was added and stir for 10 minutes. Heat up to 80°C. After 1 hour is used to react, a mixed monomer (dibenzoyl peroxide(0.9g), APDMAA(7.5g), N-(4-hydroxyphenyl)maleimide(28.5g), styrene(12g) and acrylonitrile(9g) was dissolved into ethyl cellosolve(450ml)) is dropped. The dropping was finished in 1 hour. The reaction was continued for 4 hours. After the reaction is completed. Cooled reactant to room temperature. Hydroquinone(0.5g) which was dissolved in ethyl cellosolve(50ml) was added. The reactant was stirred for 10 minutes. Then the reactant was added into 4 liters of water, so as to obtain white solid. Via the process of being filtered, being washed for three times and being dried in a vacuum oven, the copolymer carrier BB is obtained. The weight average molecular weight of the copolymer carrier BB was measured by a gel permeation chromatography (Aglilient Technologies 1120Compact LC) (GPC). The measuring conditions are: polystyrene was used as the standard; GPC column: 708 ^{∗} 300MM; detecting wavelength: 220nm; sample concentration: 1.0mg/ml; injection volume: 20µl; mobile phase: tetrahydrofuran; column temperature: 35°C. Via the gel permeation chromatography system, the weight average molecular weight Mw, the number average molecular weight Mn, the molecular weight distribution of the synthetic resin sample was measured. The weight average molecular weight Mw here concerned is 12000.

### Synthesis of ester BBE1:

A stirrer, a condenser and a dropping funnel was set to a four-necked flask(250ml). GBL(50ml) was added. The stirrer was started. The carrier resin BB(3.6g), 1- diazo-2-naphthoquinone-4-sulfuryl chloride (0.3g) was added and stirred to be dissolved. A mixture liquid of triethylamine (0. 30g) and GBL(0.5g) is dropped. The temperature was controlled between 20∼25°C. It took 1.5 hours to drop. After the dropping was finished, stirring was continued for 2 hours at the temperature 20∼25°C. The reactants was filtered. The filtrate was added into water (350ml) slowly to obtain yellow solid powder. After precipitating of the yellow solid powder is finished, the process of stirring was applied for 30 minutes. Via the process of being filtered, being washed for three times and being dried at the temperature 40°C, the ester BBE1 is obtained.

### Synthesis of ester BBE2:

A stirrer, a condenser and a dropping funnel was set to a four-necked flask(250ml). GBL(50ml) was added. The stirrer was started. The carrier resin BB(3.6g), 1- diazo-2-naphthoquinone-4-sulfuryl chloride (1.53g) was added and stirred to be dissolved. A mixture liquid of triethylamine (0. 60g) and GBL(0.8g) is dropped. The temperature was controlled between 20∼25°C. It took 1.5 hours to drop. After the dropping was finished, stirring was continued for 2 hours at the temperature 20∼25°C. The reactants was filtered. The filtrate was added into water (350ml) slowly to obtain yellow solid powder. After precipitating of the yellow solid powder is finished, the process of stirring was applied for 30 minutes. Via the process of being filtered, being washed for three times and being dried at the temperature 40°C, the ester BBE2 is obtained.

### Synthesis of ester BBE3:

A stirrer, a condenser and a dropping funnel was set to a four-necked flask(250ml). GBL(50ml) was added. The stirrer was started. The carrier resin BB(3.6g), 1- diazo-2-naphthoquinone-4-sulfuryl chloride (2.05g) was added and stirred to be dissolved. A mixture liquid of triethylamine (0.80g) and GBL(1.0g) is dropped. The temperature was controlled between 20∼25°C. It took 1.5 hours to drop. After the dropping was finished, stirring was continued for 2 hours at the temperature 20∼25°C. The reactants was filtered. The filtrate was added into water (350ml) slowly to obtain yellow solid powder. After precipitating of the yellow solid powder is finished, the process of stirring was applied for 30 minutes. Via the process of being filtered, being washed for three times and being dried at the temperature 40°C, the ester BBE3 is obtained.

### Synthesis of ester BBE4:

A stirrer, a condenser and a dropping funnel was set to a four-necked flask(250ml). GBL(50ml) was added. The stirrer was started. The carrier resin BB(3.6g), 1- diazo-2-naphthoquinone-4-sulfuryl chloride (2.3g) was added and stirred to be dissolved. A mixture liquid of triethylamine (0.91g) and GBL(1.2g) is dropped. The temperature was controlled between 20∼25°C. It took 1.5 hours to drop. After the dropping was finished, stirring was continued for 2 hours at the temperature 20∼25°C. The reactants was filtered. The filtrate was added into water (350ml) slowly to obtain yellow solid powder. After precipitating of the yellow solid powder is finished, the process of stirring was applied for 30 minutes. Via the process of being filtered, being washed for three times and being dried at the temperature 40°C, the ester BBE4 is obtained.

### Embodiments 1-4

Preparation of the lower layer coating solution L1-L4. The lower layer coating liquid of the positive image thermosensitive lithographic printing plate material precursor was prepared according to the following recipe:

| | |
|---|---|
| AUVR1 | 2.21 parts by weight |
| AUVR2 | 5.79 parts by weight |
| THPA(Puyang Henan) | 0.40parts by weight |
| crystal violet(Lintong Jiangsu) | 0.24 parts by weight |
| BBE(1-4) | 1.23 parts by weight |
| NIRD-0 10 | 0.13 parts by weight |
| GBL | 22.8 parts by weight |
| PM | 85.7 parts by weight |
| MEK | 24.4 parts by weight |

The top layer SL of the positive image thermosensitive lithographic printing plate material was prepared according to the following recipe:

| | |
|---|---|
| MEK | 47 parts by weight |
| PM | 87 parts by weight |
| NVR-2W | 4.28 parts by weight |
| NVR-1W | 4.28parts by weight |
| 2M412 | 0.49parts by weight |
| NIRD-010 | 0.352 parts by weight |
| THPA(Puyang Henan) | 0.13 parts by weight |
| 3H | 0.10 parts by weight |
| BYK Chemie, Wallingford, CT,USA | 0.0035 parts by weight |
| crystal violet(Lintong Jiangsu) | 0.19 parts by weight |

### Alternative mode

The lower layer coating liquid L5 of the positive image thermosensitive lithographic printing plate material precursor was prepared according to the following recipe:

| | |
|---|---|
| AUVR1 | 2.28 parts by weight |
| AUVR2 | 6.84 parts by weight |
| THPA(Puyang Henan) | 0.65parts by weight |
| crystal violet(Lintong Jiangsu) | 0.24 parts by weight |
| GBL | 22.8 parts by weight |
| PM | 85.7 parts by weight |
| MEK | 24.4 parts by weight |

According to the above embodiments, a method of manufacturing the positive image thermosensitive lithographic printing plate material is described as follow:
1. The preferred plate is an aluminum plate. A hydrophilic surface is obtained through the following processes:
   (1) Decontaminating the aluminum plate. Organic solvents, acids or lye is used to clean the surface of the aluminum plate. The dissolved load thereof is 5∼8g/m²;
   (2) Electrolytic graining: lipophilic of the graphic parts of the plate material should be good. Hydrophilic of blank parts of the plate material should be good. Good hydrophilic properties of blank parts need a process of graining the aluminum plate, so that blank trachoma parts are hydrophilic rather than lipophilic. The forming of graining applies process of electrolysis. An aluminum plate and graphite are used as two electrodes. The electrolyte is hydrochloric acid solution(6∼20g/1). 50Hz AC is used, wherein the current thereof is 20-100A/dm². The temperature of the liquid is 30∼60°C. The electrolysis time is 5∼90. Ra = 0.5∼0.6µm.
   (3) Anodic oxidation. In order to improve the mechanical of the aluminum plate surface, to enhance the wear resistance and to improve the hydrophilic, it is necessary to give an anodic oxidation treatment to the surface of the aluminum plate, wherein 15%∼30% sulfuric acid solution is used. Temperature is 20∼60°C. The electrolytic treatment takes 5∼250 seconds. Concentration of aluminum ion is 0.5∼5g/l. Direct current is used. The current is 1∼15A/dm². Oxide film is controlled to 2∼3g/m².
   (4) hydrophilic treatment. Commercially sodium fluoride/sodium dihydrogen phosphate sealing liquid is used in hydrophilic treatment at 42±1°C.
2. spin coating
   The obtained lower layer coating liquid L1-L5 was coated to the plate being given hydrophilic graining via the method of spin coating. The size of the plate(an aluminum plate being produced by Shanghai Strong State Printing Equipment LTD., wherein the plate has a hydrophilic layer and is used to thermosensitive plate) is 400^{∗}510^{∗}0.27mm edition group manner was by. A process of drying is applied for 3 minutes in an oven. The temperature of the oven is controlled to 150°C. Suitable rotational speed of spin coating is controlled, so that the thickness of the resulting patterns coating is 0.9g/m², so as to obtain the lower layer patterns D1-D5.
   The obtained top layer coating solution SL is coated to the patterns D1-D5 which were coated with lower layers via the method of spin coating. A process of drying is applied for 3 minutes in an oven. The temperature of the oven is controlled to 130°C. Suitable rotational speed of spin coating is controlled, so that the thickness of the resulting patterns coating is 0.8g/m², so as to obtain the lower layer patterns T1-T4 and a comparison test plate C.
3. detection method and results of the properties of the positive image thermosensitive lithographic printing plate

The above positive image thermosensitive lithographic printing plate material is treated by the following process to obtain a lithographic printing plate:
(1) expose said positive image thermosensitive lithographic printing plate material to thermal laser beams.
(2) develop the exposed positive image thermosensitive lithographic printing plate material with an alkaline developing liquid.

A SCREEN8600E plate-making machine is used. Imaging screening is 1751pi. The output resolution is 2400dpi. Scanning plate making is applied in the sample plate through different laser energy following the following exposure conditions (Table 1) and developing conditions (Table 2), and then determine the clean points through the following method:
a) Observe whether 0% point of the test pattern is clean via a 100 times magnifying glass. The clean point is expressed as energy corresponding with CM record.
b) Test density of 0% point corresponding to different energy of the testing image with a 528 type densitometer.
c) a drop of acetone is dropped to the corresponding 0% point of the testing image. After acetone volatilized, density of the region had been dropped with acetone is tested via a 528 type densitometer.
e) If the densities before being dropped with acetone and after the acetone volatilize are the same, the exposure energy of the corresponding testing pattern is deemed to clean point. The clean point is represented as CD

The test results are shown in Table 6

**TABLE 1 exposure conditions**

| plate-making machine | SCREEN8600E |
|---|---|
| Wheel speed (rpm) | 600 |
| Initial value of the exposure intensity | 30% |
| Step interval of the exposure intensity | 5% |
| exposure condition | 15 |
| remark | bring test bar itself |

**Table 2 developing conditions**

| Developing liquid | D-III-Ks thermosensitive developing liquid |
|---|---|
| developer | Kodak-T8600 |
| Developing temperature | 24°C |
| Developing speed | 25s |
| Conductivity of developing liquid | 89-91ms/cm |
| Supplement of developing liquid | 120ml/m² |

**Table 3 developing conditions**

| Developing liquid | THD200 thermosensitive developing liquid (Agfa) | Goldstar Premium thermosensitive developing liquid (Kodak) |
|---|---|---|
| developer | Kodak-T8600 | |
| Developing temperature | 23°C | 23°C |
| Developing speed | 25s | 30s |
| Conductivity of developing liquid | 75-76ms/cm | 84-86ms/cm |
| Supplement of developing liquid | 120ml/m² | |

**Table 4 Testing results**

| Sample mumber | CM | CD | P | Power | | | Place of 65% energy | | | ΔD |
|---|---|---|---|---|---|---|---|---|---|---|
| | | | | 3% | 50% | Small screen dot reduction | 3% | 50% | Small screen dot reduction | |
| T1 | 40% | 30% | 57% | 2.1% | 49.1% | 5 | 1.9% | 47.3% | 4 | 3.87% |
| T2 | 40% | 30% | 52% | 2.2% | 49.3% | 4-5 | 2.0% | 47.6% | 4 | 3.67% |
| T3 | 40% | 230% | 62% | 2.2% | 49.0% | 4-5 | 2.0% | 47.9% | 4 | 2.60% |
| T4 | 40% | 330% | 62% | 2.2% | 49.2% | 5 | 2.1% | 48.4% | 4-5 | 2.69% |
| C | 40% | 30% | 47% | 1.9% | 48.1% | 3-4 | 1.5% | 43.5% | 2 | 4.98% |

### 4. testing the fitness of the developing liquid:

THD200 thermosensitive developing liquid of Agfa and Goldstar Premium developing liquid of Kodak are selected. A SCREEN8600E plate-making machine is used. Imaging screening is 1751pi. The output resolution is 2400dpi. Scanning plate making is applied in the sample plate through different laser energy following the following exposure conditions (Table 1) and developing conditions (Table 3). The testing result as table 5.

**Table 5 Testing results**

| THD200 developing liquid of Agfa | | | | | | | | | | |
|---|---|---|---|---|---|---|---|---|---|---|
| Sample mumber | CM | CD | P | Power | | | Place of 65% energy | | | ΔD |
| | | | | 3% | 50% | Small screen dot reduction | 3% | 50% | Small screen dot reduction | |
| T1 | 50% | 45% | 62% | 2.10% | 48.80% | 4 | 2.10% | 47.90% | 4 | 1.32% |
| T2 | 45% | 50% | 65% | 2.20% | 48.20% | 4 | 2.20% | 48.20% | 4 | 2.07% |
| T3 | 45% | 50% | 67% | 2.40% | 49.50% | 5 | 2.40% | 49.50% | 5 | 1.01% |
| T4 | 40% | 45% | 60% | 2.30% | 49.30% | 4-5 | 2.30% | 48.70% | 4 | 1.92% |
| C | 45% | 50% | 70% | 2.30% | 48.70% | 3-4 | 2.40% | 50.00% | 2 | 2.10% |

| Goldstar Premium developing liquid of Kodak | | | | | | | | | | |
|---|---|---|---|---|---|---|---|---|---|---|
| T1 | 35% | 35% | 57% | 1.9% | 48.2% | 4 | 1.7% | 46.4% | 3-4 | 9.83% |
| T2 | 35% | 40% | 62% | 2.1% | 49.0% | 4 | 1.9% | 47.3% | 4 | 8.18% |
| T3 | 40% | 45% | 62% | 2.3% | 49.2% | 5 | 2.1% | 48.2% | 4 | 9.96% |
| T4 | 40% | 45% | 62% | 2.1% | 48.6% | 4 | 2.1% | 47.8% | 4 | 9.35% |
| C | 40% | 40% | 62% | 2.2% | 49.2% | 4 | 2.0% | 47.8% | 4 | 10.21% |

**Table 6 The experimental results**

| Sample number | Sample introduction | Power | | 65% | | Small screen dot reduction at the place of energy | | Film off condition | |
|---|---|---|---|---|---|---|---|---|---|
| | | 3% | 50% | 3% | 50% | Power | 65% | 1^{∗}1 | 2^{∗}2 |
| T1 | Double layer | 2.1 | 49.1 | 1.9 | 47.3 | 5 | 4-5 | little | √ |
| | After take of top layer | 1.8 | 48.4 | 1.8 | 46.6 | 4-5 | 4 | | |
| T2 | Double layer | 2.2 | 49.3 | 2.0 | 47.6 | 5 | 4-5 | √ | √ |
| | After take of top layer | 1.9 | 48.1 | 1.8 | 46.7 | 4-5 | 4-5 | | |
| T3 | Double layer | 2.2 | 49.0 | 2.0 | 47.9 | 5 | 4-5 | √ | √ |
| | After take of top layer | 1.9 | 48.4 | 1.8 | 46.5 | 4-5 | 4-5 | | |
| T4 | Double layer | 2.2 | 49.2 | 2.1 | 48.4 | 5 | 4-5 | √ | √ |
| | After take of top layer | 1.8 | 48.3 | 1.8 | 46.9 | 4-5 | 4-5 | | |
| C | Double layer | 1.9 | 48.1 | 1.5 | 43.5 | 3-4 | 2 | × | √ |
| | After take of top layer | 1.4 | 45.4 | 1.1 | 40.7 | 3 | 2 | | |

According to the above experimental results, the lower layer is the key to determine the substance screen dots. It leads to outlets "pull erosion" phenomenon to resolve the problem of ink remaining at the bottom only rely on adjusting the proportion of alkali-soluble group of the copolymer resin structural units, or to help dissolving and clearing the copolymer resin in the non-imaging region via adding development accelerators. The whole screen dot has an inverted trapezoidal shape. Especially, fine mesh wire having size of 1*1 and 3% screen dot usually show a "virtual stay" phenomenon. The remaining of the lower layer screen dots mainly dependents on the alkali resistance of the lower layer itself. If the energy radiation is same and the developer contact time is same, only a small amount of the lower layer will be eroded by the developer. And the "dig dissolve" effect is little. It is the key to ensure the lower layer screen dots. Adding dissolution inhibitor according to the present invention to the lower layer can avoid "digging erosion" phenomenon during the process of developing of the exposed regions, so as to protect the lower layer screen dots. The experiment according to the present invention fully proved the conclusions of the present invention.

One skilled in the art will understand that the embodiment of the present invention as shown in the drawings and described above is exemplary only and not intended to be limiting.

## Claims

1. A positive image thermosensitive lithographic plate material, comprising a hydrophilic layer, wherein said hydrophilic layer is coated with a lower layer and a top layer in turn, the lower layer being the first coating and the top layer coating the lower layer, wherein said hydrophilic layer is sensitive to infrared radiation;
wherein said lower layer of said hydrophilic layer comprises at least one thermosensitive composition consisting of alkali-soluble copolymers, near infrared absorbing dye, dissolution inhibitors, development accelerators and background coloring dye and solvent thereof, wherein said top layer comprises at least one thermosensitive composition consists of novolac resin films, near infrared absorbing dye, dissolution inhibitors, development accelerators, surfactants and background coloring dye and solvent thereof;
wherein said alkali-soluble copolymer resin is an acrylic copolymer of formula (I), which contains at least one structural unit of alpha-Toluenesulfonamide Acrylamide monomer, wherein the molecular weight of the copolymer is 1,000 to 100,000, wherein the mass fraction of alpha-Toluenesulfonamide Acrylamide monomer in the copolymer is 5% to 70%, wherein the mass percentage content of alkali-soluble resin in the lower thermal composition is 60 to 80%; 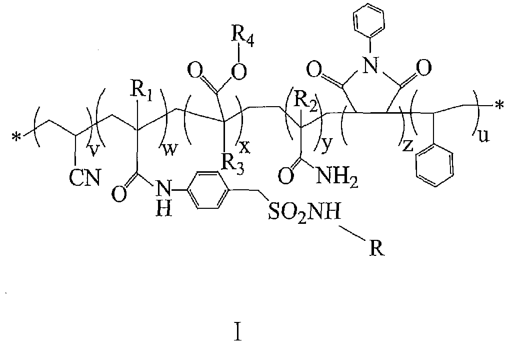 wherein R is selected from the group consisting of -H, -(C1 ∼ C4) alkyl and aryl; wherein R₁, R₂ and R₃ is independently selected from the group consisting of -H and -CH₃ ; wherein R₄ is selected from the group consisting of-CH₃ and -C₂H₅; wherein v, w, x, y, z and u respectively represents mass fraction of each monomer in the copolymer molecule, wherein the mass fraction of each said monomer is 0% to 70%; wherein the sum of the monomers represented by v, w, x, y, z and u is 100%;
wherein the dissolution inhibitor used in the lower layer is ester of diazonaphthoquinone sulfonyl chloride and acrylic copolymer containing N-(4-hydroxyphenyl) maleimide cyclic units which is represented by formula (II), wherein the mass percentage of ester in the lower layer thermosensitive composition is 10∼30%; 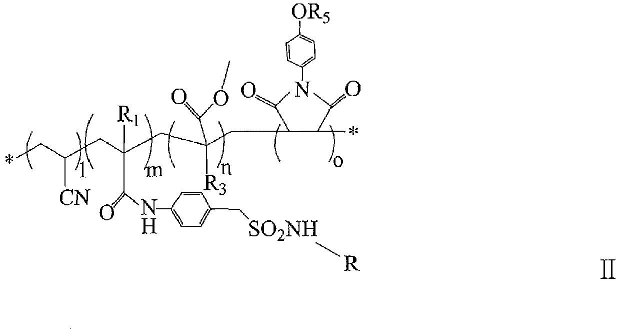 wherein R is selected from the group consisting of -H, -(C1∼C4) alkyl and aryl; wherein R₁ and R₃ is independently selected from the group consisting of-H and CH₃; wherein R₅ is diazonaphthoquinone sulfonate of formula (III), wherein 1, m, n and o respectively represents mass fraction of each monomer in the copolymer molecule, wherein the sum of the mass fractions of components respectively being representative by 1, m, n and o, is 100%, wherein the mass fraction of component being representative by o is 40% ∼50%, wherein the esterification rate thereof is 50% ∼90%.

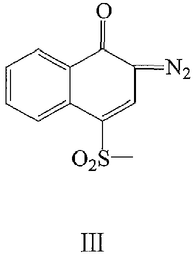

2. The positive image thermosensitive lithographic plate material, as recited in claim 1, wherein the dissolution inhibitor used in said top layer is 1,2-naphthoquinone-2-diazo-4-sulfonic acid ester compound, wherein the esterified precursor thereof is low molecular weight polyhydric phenol compounds and pyrogallol-acetone polycondensates, wherein the weight average molecular weight of the esterified precursor is 50∼5000, wherein Mw/Mn thereof is 1.5∼20, wherein hydroxy esterification rate is 10%∼80% of the initial hydroxyl groups, wherein the mass percentage of dissolution inhibitor in said top layer thermosensitive composition is 2%∼5%.

3. The positive image thermosensitive lithographic plate material, as recited in claim 1, wherein the phenolic resin in said top layer is selected from the composition consisting of phenol, m-cresol, o-cresol, p-cresol, phenol and m-cresol(mole ratio thereof is 3:7∼7:3), phenol and tert-butyl phenol(mole ratio thereof is 3:1∼1.5:1), m-cresol and p-cresol (mole ratio thereof is 9:1∼5:5), m-,o-cresol, 2,4-xylenol, 3,5-xylenol and m-/p- mixed cresol modified by N-phenyl maleimide, wherein the weight average molecular weight thereof is 8000∼30000, wherein the amount thereof being added is 86.5% ∼ 89.5% of the whole top layer heat-sensitive composition in weight.

4. The positive image thermosensitive lithographic plate material, as recited in claim 1, wherein the lower layer and said top layer is added with near-infrared absorbing dye, wherein the maximum absorption peak of the dye is 700nm-1300nm.

5. The positive image thermosensitive lithographic plate material, as recited in claim 4, wherein the near infrared absorbing cyanine dye is one kind of dye or a mixture of two kinds of dye which have different maximum absorption peak values, wherein the ratio of the two kinds dyes is 1:2∼2:1, wherein the total amount of the near-infrared absorbing dyes is 0.5 to 2% in the lower layer thermal composition and is 1% to 4% in the top thermosensitive composition.

6. The positive image thermosensitive lithographic plate material, as recited in claim 1, the weight of coating of said lower layer is 0.8-1.2g/m², wherein the weight of said top layer coating is 0.6-1.0g/m².

## Patentansprüche

1. Wärmeempfindliches lithographisches Positivbild-Plattenmaterial mit einer hydrophilen Schicht, wobei die hydrophile Schicht wiederum mit einer unteren Lage und einer oberen Lage beschichtet ist, wobei die untere Lage die erste Beschichtung darstellt und die obere Lage die untere Lage bedeckt, wobei die hydrophile Schicht gegenüber Infrarotstrahlung empfindlich ist;
wobei die untere Lage der hydrophilen Schicht eine wärmeempfindliche Zusammensetzung umfasst, die aus einem alkalilöslichen Copolymer, einem im nahen Infrarot absorbierenden Farbstoff, einem Lösungsinhibitor, einem Entwicklungsbeschleuniger, einem Hintergrundfarbstoff und einem Lösungsmittel dafür besteht,
wobei die obere Lage mindestens eine wärmeempfindliche Zusammensetzung umfasst, die aus Novolac-Harzfilmen, einem im nahen Infrarot absorbierenden Farbstoff, Lösungsinhibitoren, Entwicklungsbeschleunigern, Tensiden und einem Farbstoff zum Einfärben des Hintergrunds sowie einem Lösungsmittel dafür besteht;
wobei das alkalilösliche Copolymerharz ein Acrylcopolymer der Formel (I) darstellt, das mindestens eine Struktureinheit aus alpha-Toluolsulfonamid-Acrylamidmonomer enthält, wobei das Molekulargewicht des Copolymers 1.000 bis 100.000 beträgt, wobei der Masseanteil von alpha-Toluolsulfonamid-Acrylamidmonomer in dem Copolymer 5% bis 70% beträgt, wobei der Anteil an alkalilöslichem Harz in der wärmeempfindlichen Zusammensetzung der unteren Lage 60 bis 80 Gew.-% beträgt; 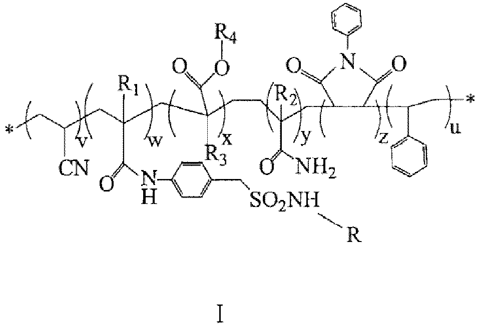 worin R aus der aus -H, -(C1 ∼ C4)Alkyl und -Aryl bestehenden Gruppe ausgewählt ist; worin R₁, R₂ und R₃ unabhängig voneinander aus der aus -H und - CH₃ bestehenden Gruppe ausgewählt sind; worin R₄ aus der aus -CH₃ und -C₂H₅ bestehenden Gruppe ausgewählt ist; worin v, w, x, y, z und u jeweils den Masseanteil jedes Monomers in dem Copolymermolekül darstellen, wobei der Masseanteil eines jeden solchen Monomers 0% bis 70% beträgt; wobei die Summe der durch v, w, x, y, z und u dargestellten Monomere 100% beträgt;
wobei der bei der unteren Lage verwendete Lösungsinhibitor einen Ester von Diazonaphthochinonsulfonylchlorid und ein Acrylcopolymer darstellt, das durch Formel (II) repräsentierte cyclische N-(4-Hydroxyphenyl)maleimid-Einheiten enthält, wobei der Anteil von Ester in der wärmeempfindlichen Zusammensetzung der unteren Lage 10∼30 Gew.-% beträgt; 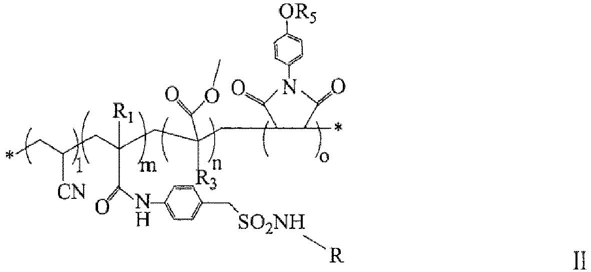 worin R aus der aus -H, -(C1 ∼ C4)Alkyl und -Aryl bestehenden Gruppe ausgewählt ist; worin R₁ und R₃ unabhängig voneinander aus der aus -H und CH₃ bestehenden Gruppe ausgewählt sind; worin R₅ Diazonaphthochinonsulfonat der Formel (III) darstellt, wobei l, m, n und o jeweils den Masseanteil jedes Monomers in dem Copolymermolekül darstellt, wobei die Summe der jeweils durch l, m, n und o dargestellten Masseanteile der Komponenten 100% beträgt, wobei der durch o dargestellte Masseanteil einer Komponente 40%~50% beträgt, wobei deren Veresterungsrate 50%∼90% beträgt.

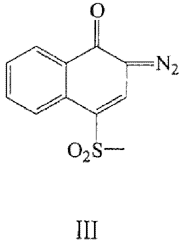

2. Wärmeempfindliches lithographisches Positivbild-Plattenmaterial nach Anspruch 1, wobei der bei der oberen Lage verwendete Lösungsinhibitor eine 1,2-Naphthochinon-2-diazo-4-sulfonsäureester-Verbindung ist, wobei es sich bei deren verestertem Vorläufer um mehrwertige Phenolverbindungen von niedrigem Molekulargewicht und Pyrogallol-Aceton-Polykondensate handelt, wobei das gewichtsgemittelte Molekulargewicht des veresterten Vorläufers 50~5000 beträgt, wobei dessen Mw/Mn 1,5∼20 beträgt, wobei die Hydroxyveresterungsrate 10%~80% der anfänglichen Hydroxylgruppen beträgt, wobei der Anteil des Lösungsinhibitors in der wärmeempfindlichen Zusammensetzung der oberen Lage 2~5 Gew.-% beträgt.

3. Wärmeempfindliches lithographisches Positivbild-Plattenmaterial nach Anspruch 1, wobei das Phenolharz in der oberen Lage aus der aus Phenol, m-Kresol, o-Kresol, p-Kresol, Phenol und m-Kresol (mit einem Molverhältnis von 3:7∼7:3), Phenol und t-Butylphenol (mit einem Molverhältnis von 3:1∼1,5:1), m-Kresol und p-Kresol (mit einem Molverhältnis von 9:1∼5:5), m-, o-Kresol, 2,4-Xylenol, 3,5-Xylenol und einer mit N-Phenylmaleimid modifizierten m-/p-Kresolmischung bestehenden Zusammensetzung ausgewählt ist, wobei dessen gewichtsgemitteltes Molekulargewicht 8.000∼30.000 beträgt, wobei die zugesetzte Menge davon 86,5∼89,5 Gew.-% der gesamten wärmeempfindlichen Zusammensetzung der oberen Lage beträgt.

4. Wärmeempfindlichens lithographisches Positivbild-Plattenmaterial nach Anspruch 1, wobei die untere Lage und die obere Lage mit einem im nahen Infrarot absorbierenden Farbstoff versehen ist, wobei der maximale Absorptionspeak des Farbstoffs 700 nm-1300 nm beträgt.

5. Wärmeempfindliches lithographisches Positivbild-Plattenmaterial nach Anspruch 4, wobei der im nahen Infrarot absorbierende Cyaninfarbstoff eine Farbstoffart oder eine Mischung von zwei Farbstoffarten darstellt, die unterschiedliche Werte für den maximalen Absorptionspeak haben, wobei das Verhältnis der beiden Arten von Farbstoffen 1:2∼2:1 beträgt, wobei die Gesamtmenge der im nahen Infrarot absorbierenden Farbstoffe 0,5% bis 2% bei der wärmeempfindlichen Zusammensetzung der unteren Lage und 1% bis 4% bei der wärmeempfindlichen Zusammensetzung der oberen Lage beträgt.

6. Wärmeempfindliches lithographisches Positivbild-Plattenmaterial nach Anspruch 1, wobei das Gewicht der Beschichtung der unteren Lage 0,8-1,2 g/m² beträgt, wobei das Gewicht Beschichtung der oberen Lage 0,6-1,0 g/m² beträgt.

## Revendications

1. Matériau de plaque lithographique thermosensible à image positive, comprenant une couche hydrophile, dans lequel ladite couche hydrophile est appliquée successivement avec une couche inférieure et une couche supérieure, la couche inférieure étant le premier revêtement et la couche supérieure revêtant la couche inférieure, dans lequel ladite couche hydrophile est sensible à un rayonnement infrarouge ;
dans lequel ladite couche inférieure de ladite couche hydrophile comprend une composition thermosensible consistant en un copolymère soluble dans les solutions alcalines, un colorant absorbant dans l'infrarouge proche, un inhibiteur de dissolution, un accélérateur de développement, un colorant de fond et un solvant pour ceux-ci,
dans lequel ladite couche supérieure comprend au moins une composition thermosensible consistant en des films de résine Novolaque, un colorant absorbant dans l'infrarouge proche, des inhibiteurs de dissolution, des accélérateurs de développement, des tensioactifs et un colorant colorant le fond et un solvant pour ceux-ci ;
dans lequel ladite résine copolymère soluble dans les solutions alcalines est un copolymère acrylique de formule (I), qui contient au moins un motif structural de monomère acrylamide alpha-toluènesulfonamide, la masse moléculaire du copolymère valant de 1 000 à 100 000, la fraction massique du monomère acrylamide alpha-toluènesulfonamide dans le polymère valant de 5 % à 70 %, le pourcentage en masse de la résine soluble dans les solutions alcalines contenue dans la composition thermique inférieure valant de 60 à 80 % ; 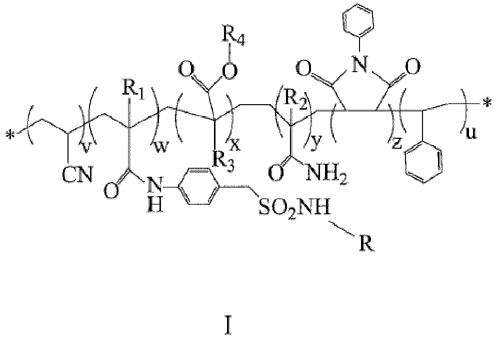 formule dans laquelle R est choisi dans l'ensemble constitué par -H, un groupe -alkyle en C₁-C₄ et un groupe aryle ; dans laquelle R₁, R₂ et R₃ sont choisis indépendamment dans l'ensemble constitué par -H et -CH₃ ; dans laquelle R₄ est choisi dans l'ensemble constitué par -CH₃ et -C₂H₅ ; dans laquelle v, w, x, y, z et u représentent respectivement la fraction massique de chaque monomère dans la molécule de copolymère, dans lequel la fraction massique de chaque dit monomère vaut de 0 % à 70 % ; dans lequel la somme des monomères représentés par v, w, x, y, z et u est égale à 100 % ;
dans lequel l'inhibiteur de dissolution utilisé dans la couche inférieure consiste en ester de diazonaphtoquinone chlorure de sulfonyle et copolymère acrylique contenant des motifs cycliques N-(4-hydroxyphényl)maléimide qui est représenté par la formule (II), le pourcentage en masse d'ester dans la composition thermosensible de la couche inférieure valant de 10 à 30 % ; 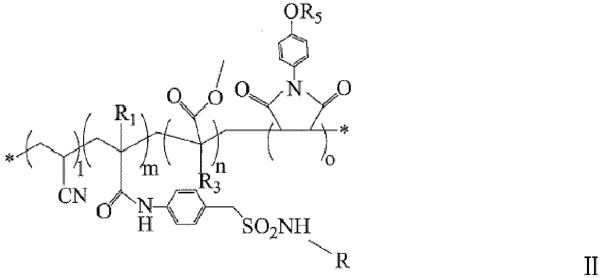 formule dans laquelle R est choisi dans l'ensemble constitué par -H, un groupe -alkyle en C₁-C₄ et un groupe aryle ; dans laquelle R₁ et R₃ sont choisis indépendamment dans l'ensemble constitué par -H et -CH₃ ; dans laquelle R₅ est le sulfonate de diazonaphtoquinone de formule (III), dans laquelle l, m, n et o représentent respectivement la fraction massique de chaque monomère dans la molécule de copolymère, dans lequel la somme des fractions massiques des composants représentées respectivement par l, m, n et o, est égale à 100 %, la fraction massique du composant représentée par o valant de 40 % à 50 %, le taux d'estérification de celui-ci valant de 50 % à 90 %.

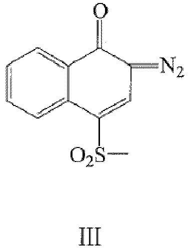

2. Matériau de plaque lithographique thermosensible à image positive, tel qu'énoncé dans la revendication 1, dans lequel l'inhibiteur de dissolution utilisé dans ladite couche supérieure est le composé ester d'acide 1,2-naphtoquinone-2-diazo-4-sulfonique, dans lequel le précurseur estérifié de ce dernier consiste en des composés phénol polyhydriques de faible masse moléculaire et des produits de polycondensation de pyrogallol-acétone, dans lequel la masse moléculaire moyenne en poids du précurseur estérifié vaut de 50 à 5 000, dans lequel le rapport Mw/Mn de celui-ci vaut de 1,5 à 20, dans lequel le taux d'estérification des groupes hydroxy vaut de 10 % à 80 % des groupes hydroxy initiaux, dans lequel le pourcentage en masse d'inhibiteur de dissolution dans ladite composition thermosensible de la couche supérieure vaut de 2 % à 5 %.

3. Matériau de plaque lithographique thermosensible à image positive, tel qu'énoncé dans la revendication 1, dans lequel la résine phénolique dans ladite couche supérieure est choisie parmi la composition consistant en phénol, m-crésol, o-crésol, p-crésol, phénol et m-crésol (en un rapport molaire de 3:7 à 7:3), phénol et tert-butylphénol (en un rapport molaire de 3:1 à 1,5:1), m-crésol et p-crésol (en un rapport molaire de 9:1 à 5:5), m-, o-crésol, 2,4-xylénol, 3,5-xylénol et m-/p-crésol mélangés modifiée par du N-phénylmaléimide, la masse moléculaire moyenne en poids de celle-ci valant de 8 000 à 30 000, la quantité de celle-ci qui est ajoutée valant de 86,5 % à 89,5 %, en poids de la composition thermosensible de la couche supérieure totale.

4. Matériau de plaque lithographique thermosensible à image positive, tel qu'énoncé dans la revendication 1, dans lequel on ajoute à la couche inférieure et à ladite couche supérieure un colorant absorbant dans l'infrarouge proche, le pic d'absorption maximale du colorant se situant dans la gamme de 700 nm à 1 300 nm.

5. Matériau de plaque lithographique thermosensible à image positive, tel qu'énoncé dans la revendication 4, dans lequel le colorant cyanine absorbant dans l'infrarouge proche est un type de colorant ou un mélange de deux types de colorants qui ont différentes valeurs de pics d'absorption maximale, le rapport des deux types de colorants valant de 1:2 à 2:1, la quantité totale des colorants absorbant dans l'infrarouge proche valant de 0,5 % à 2 % dans la composition thermique de la couche inférieure et valant de 1 % à 4 % dans la composition thermosensible supérieure.

6. Matériau de plaque lithographique thermosensible à image positive, tel qu'énoncé dans la revendication 1, le poids d'application de ladite couche inférieure vaut de 0,8 à 1,2 g/m², le poids d'application de ladite couche supérieure valant de 0,6 à 1,0 g/m².
